# FASCICULE DE BREVET EUROPEEN

(11) **EP 2 502 877 B1**
(45) Date de publication et mention de la délivrance du brevet: **02.10.2013**
(21) Numéro de dépôt: 11002399.1
(22) Date de dépôt: 23.03.2011
(51) Int. Cl.: B81C 99/00, G04D 3/00

(54) **Procédé de fabrication d'une pièce composite notamment pour mouvement d'horlogerie**
Verfahren zur Herstellung eines Verbundwerkstoffteils, insbesondere für Uhrwerk
Method for manufacturing a composite part, notably for a clock movement

(43) Date de publication de la demande: 26.09.2012
(73) Titulaire: Patek Philippe SA Genève, 1204 Genève (CH)
(72) Inventeur: Hide, James, 1228 Plan-les Ouates (CH); Maier, Frédéric, 2000 Neuchâtel (CH)
(74) Mandataire: Micheli & Cie SA

(56) Documents cités:
- WO-A2-2008/135817
- US-A1- 2002 005 359
- US-A1- 2006 000 795
- Q. LUO ET AL: "Stabilization of Alumina Slurry for Chemical-Mechanical Polishing of Copper", LANGMUIR, vol. 12, no. 15, 1 janvier 1996 (1996-01-01), pages 3563-3566, XP55004226, ISSN: 0743-7463, DOI: 10.1021/la960062w

## Description

La présente invention concerne un procédé de fabrication d'une pièce composite notamment pour un mouvement d'horlogerie, plus particulièrement un procédé de micro-fabrication d'une telle pièce, c'est-à-dire un procédé dont la précision d'usinage est de l'ordre du micron ou inférieure au micron.

Dans la demande de brevet WO 2008/135817 de la présente demanderesse sont décrits des composants horlogers comprenant une structure usinée par gravure ionique réactive profonde DRIE (Deep Reactive Ion Etching) et une ou des parties métalliques électro-formées dans des cavités de la structure. La structure est par exemple en silicium, diamant, quartz, verre ou carbure de silicium. Elle peut aussi être en silicium recouvert d'une couche d'oxyde de silicium. Dans le cas de composants tels qu'un balancier ou une masse oscillante, les parties métalliques sont situées à la périphérie de la structure de manière à augmenter le rapport moment d'inertie/masse, respectivement balourd/masse, du composant. Une partie métallique annulaire peut aussi être électro-formée dans une cavité centrale de la structure pour permettre le chassage du composant sur un axe.

Pendant la fabrication de ces composants horlogers, à la fin de l'électro-formage des parties métalliques, ces dernières s'étendent au-delà de la hauteur des cavités. Une opération de mise à niveau (rodage) est donc effectuée pour que les surfaces exposées des parties métalliques affleurent la surface de la structure. En pratique, une telle mise à niveau est nécessaire non seulement pour des raisons esthétiques mais également, dans le cas du balancier, pour définir une référence précise quant à la quantité de métal présente dans les cavités et faciliter ainsi les opérations d'équilibrage par enlèvement de matière.

Pour ne pas casser ni user le silicium ou autre matériau fragile dans lequel est faite la structure, ou, le cas échéant, pour ne pas user la couche d'oxyde de silicium recouvrant le silicium, des masques doivent être utilisés lors du rodage de manière à ne laisser exposées que les parties métalliques. Ces masques, de même que leur positionnement sur la structure, doivent être extrêmement précis. De plus, étant réalisés en métal, ils s'usent au contact de l'abrasif de rodage, ce qui nécessite de veiller à ce que le rodage soit terminé avant leur usure complète. Enfin, ils peuvent gêner ou ralentir l'opération de rodage, et empêchent l'obtention d'une bonne qualité d'affleurement entre les surfaces de la structure et des parties métalliques.

La présente invention vise à remédier, en partie au moins, aux inconvénients précités et propose à cette fin un procédé de fabrication d'une pièce composite, notamment pour un mouvement horloger, comprenant les étapes suivantes :
- réaliser une structure par gravure d'un premier matériau,
- former au moins un revêtement sur la structure, la structure revêtue obtenue comprenant une surface extérieure,
- remplir d'un deuxième matériau, différent du premier matériau, et par électro-formage, au moins une cavité définie par la structure revêtue, le revêtement ou l'un au moins des revêtements étant en un matériau non conducteur ou étant revêtu d'une couche sacrificielle non conductrice afin d'éviter que pendant l'électro-formage le deuxième matériau se forme aussi sur la structure revêtue ailleurs que dans ladite au moins cavité, et
- abraser au moins une partie exposée du deuxième matériau au moyen d'une matière abrasive,
caractérisé en ce que le revêtement ou ledit un au moins des revêtements présente une dureté, exprimée en pascals, égale à au moins 80% de la dureté de la matière abrasive.

Par cette grande dureté relativement à la matière abrasive, le revêtement ou ledit un au moins des revêtements n'est pas ou est peu affecté par l'opération d'abrasion, ce qui lui permet de protéger le premier matériau pendant cette opération. Le recours aux masques de protection de la technique antérieure peut dès lors être évité et l'opération d'abrasion peut être considérablement simplifiée. L'abrasion peut être effectuée sans entraves et donc de manière plus efficace et précise.

De préférence, le revêtement ou ledit un au moins des revêtements est au moins aussi dur que la matière abrasive.

Typiquement, au moins une partie de ladite surface extérieure adjacente à ladite partie exposée du deuxième matériau est laissée exposée pendant l'opération d'abrasion et est de préférence soumise à l'opération d'abrasion.

Dans un mode de réalisation particulièrement avantageux, l'opération d'abrasion est effectuée au moyen d'un outil mécanique comprenant ladite matière abrasive, et l'outil mécanique entre en contact avec le revêtement ou ledit un au moins des revêtements pendant l'opération d'abrasion pour faciliter l'obtention d'un affleurement entre le deuxième matériau et le revêtement ou ledit un au moins des revêtements. Une excellente qualité d'affleurement peut ainsi être obtenue.

Avantageusement, le revêtement ou ledit un au moins des revêtements est formé sur sensiblement toutes les surfaces de la structure. De cette manière, toute la surface extérieure de la pièce peut être laissée exposée pendant l'opération d'abrasion et peut même être soumise à cette opération.

L'opération d'abrasion est par exemple un rodage et/ou une rectification et/ou un polissage.

Le revêtement ou ledit un au moins des revêtements peut être formé par dépôt chimique en phase vapeur, dépôt physique en phase vapeur, pulvérisation, évaporation, trempage ou traitement thermique.

Le premier matériau est par exemple du silicium, du quartz, du verre, du carbure de silicium, de l'alumine, de l'oxyde de zirconium ou une autre céramique.

Le revêtement ou ledit un au moins des revêtements peut être en l'une des matières suivantes : diamant, carbure de silicium, alumine, carbure de tungstène, nitrure de silicium.

La matière abrasive peut elle aussi être l'une des matières suivantes: diamant, carbure de silicium, alumine, carbure de tungstène, nitrure de silicium.

De préférence, le premier matériau est du silicium et le revêtement ou ledit un au moins des revêtements est en diamant ou carbure de silicium.

Le deuxième matériau est typiquement un métal.

Dans une première application de l'invention, le revêtement ou ledit un au moins des revêtements est plus dur que le premier matériau.

Dans une deuxième application de l'invention, cumulable avec la première application, un revêtement intermédiaire est formé entre la structure et ledit un au moins des revêtements et ledit un au moins des revêtements est plus dur que ce revêtement intermédiaire.

La pièce composite est par exemple un composant horloger choisi parmi les composants suivants : balancier, masse oscillante, roue, pignon, came, ancre, plateau, ressort spiral, ressort sautoir.

D'autres caractéristiques et avantages de la présente invention apparaîtront à la lecture de la description détaillée suivante faite en référence aux dessins annexés dans lesquels :
- la figure 1 est une vue plane de dessus d'un balancier pour mouvement d'horlogerie obtenu par le procédé selon l'invention ;
- la figure 2 est une vue de profil, partiellement coupée suivant un demi-axe II-II, du balancier illustré à la figure 1 ; et
- la figure 3 montre schématiquement, avec des vues en coupe partielles, des étapes successives du procédé selon l'invention.

Dans la description qui suit, les termes « inférieur » et « supérieur» seront employés en relation avec la position de la pièce telle qu'elle apparaît sur les figures et non pas nécessairement avec la position de la pièce dans le mécanisme dont elle est destinée à faire partie.

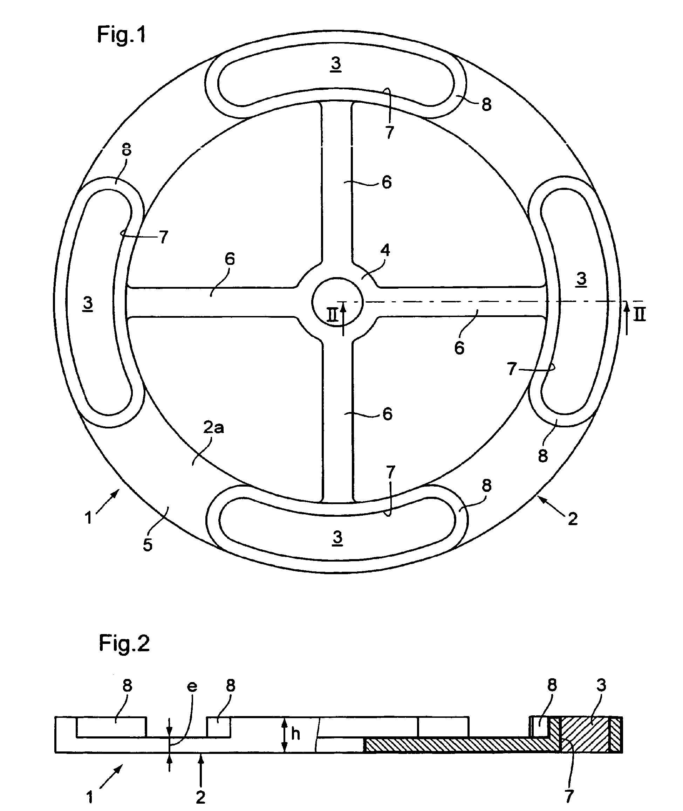

Un exemple de pièce composite fabriquée selon le procédé selon l'invention est illustré aux figures 1 et 2. Dans cet exemple, la pièce composite est un balancier 1 pour un organe réglant de type balancier - spiral d'un mouvement d'horlogerie mécanique. Le balancier 1 comprend une structure 2 ayant une faible masse volumique et, à la périphérie de la structure 2, des parties dites lourdes 3, typiquement métalliques, ayant une masse volumique élevée. La structure 2 comprend une planche 2a d'épaisseur e, typiquement constante. La planche 2a présente une partie centrale annulaire 4 à travers laquelle peut passer l'arbre sur lequel est destiné à être monté le balancier 1, une serge 5, par exemple annulaire, des bras 6 reliant la partie centrale 4 à la serge 5 et, dans la serge 5, des cavités 7 dans lesquelles sont situées les parties lourdes 3. Dans l'exemple représenté, la structure 2 comprend aussi des rebords 8 faisant saillie sur la surface supérieure de la planche 2a. Ces rebords 8 prolongent en hauteur la paroi des cavités 7, permettant aux cavités 7 et donc aux parties lourdes 3 qui les remplissent d'avoir une plus grande hauteur ou épaisseur h que l'épaisseur e de la planche 2a. Les cavités 7 et leurs parties lourdes 3 ont une forme allongée et courbe qui suit le contour circulaire de la structure 2 et sont régulièrement réparties le long de ce contour circulaire. Le nombre et les dimensions des parties lourdes 3 peuvent varier. Leur fonction est d'alourdir la serge 5 afin d'augmenter le rapport moment d'inertie sur masse du balancier 1.

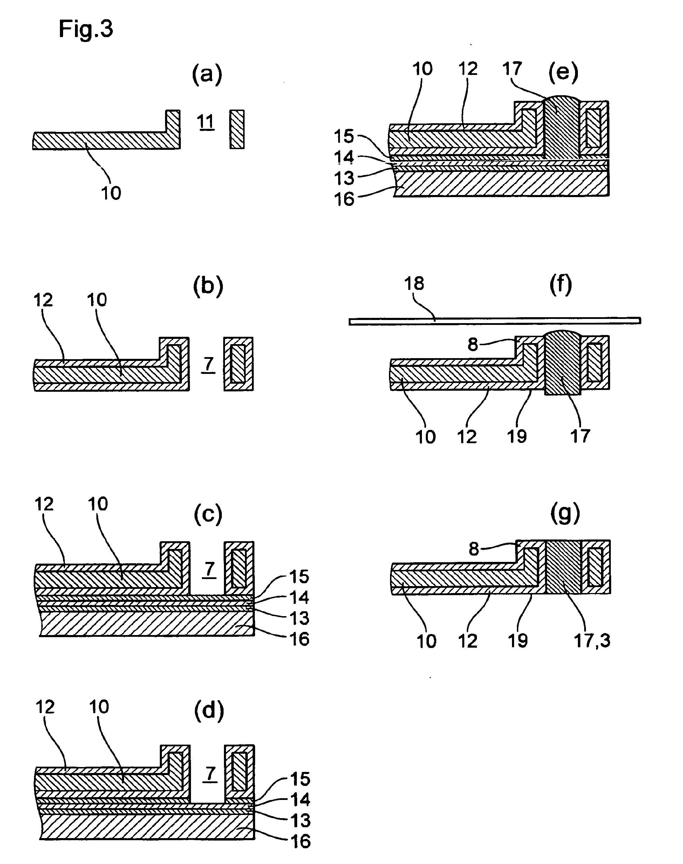

En référence à la figure 3, un procédé selon un mode de réalisation de l'invention pour fabriquer le balancier 1 illustré aux figures 1 et 2 comprend une première étape (figure 3(a)) au cours de laquelle une structure 10 comprenant des cavités traversantes 11 (dont une seule est visible) est obtenue par gravure ionique réactive profonde (DRIE) d'une plaque de matériau de base tel que le silicium, le quartz, le verre ou une céramique telle que le carbure de silicium, l'alumine (corindon) ou l'oxyde de zirconium. Dans l'exemple représenté, la structure 10 est à deux niveaux, qui sont le résultat de deux étapes de gravure successives, et les cavités 11 sont réalisées dans les parties plus épaisses de la structure 10, définissant les rebords 8. A une deuxième étape (figure 3(b)), un revêtement 12 est formé sur toutes les surfaces de la structure 10 par exemple par un procédé de dépôt chimique en phase vapeur (CVD), de dépôt physique en phase vapeur (PVD), de pulvérisation, d'évaporation, de trempage ou de traitement thermique en fonction du matériau utilisé pour le revêtement 12. Ce matériau du revêtement 12 présente une plus grande dureté que le matériau de base, et est par exemple le diamant, le carbure de silicium, l'alumine (corindon), le carbure de tungstène, le carbure de tungstène enrichi en carbone (matériau multicouche connu sous l'acronyme anglais WCC) ou le nitrure de silicium. La structure revêtue 10,12 obtenue à la deuxième étape constitue la structure 2 du balancier 1. A une troisième étape (figure 3(c)), une première couche de résine photosensible 13, une couche métallique 14 et une seconde couche de résine photosensible 15 sont successivement formées sur une plaque de support 16 en silicium ou pyrex, par exemple, puis la plaque 16 avec ses couches 13, 14, 15 et la structure revêtue 10, 12 sont assemblées par collage, la couche de résine photosensible 15 servant de colle. A une quatrième étape (figure 3(d)), les parties exposées de la résine photosensible 15, c'est-à-dire les parties se trouvant en regard des cavités 7 de la structure revêtue 10, 12, sont enlevées par un procédé photolithographique en utilisant par exemple la structure 10, 12 comme masque. A une cinquième étape (figure 3(e)), du métal est formé dans les cavités 7 par électro-formage (croissance galvanique) à partir des parties exposées de la couche métallique 14 et en utilisant les cavités 7 comme moules, de manière à former des parties métalliques 17 remplissant les cavités 7 et intimement liées au revêtement 12 qui recouvre la paroi des cavités 7. Ces parties métalliques 17 correspondent aux parties lourdes 3 du balancier 1. Le métal choisi pour remplir les cavités 7 est un métal de grande masse volumique tel que l'or ou le platine. A une sixième étape du procédé, la plaque 16 et les couches 13, 14, 15 sont enlevées (figure 3(f)).

Les parties métalliques 17 obtenues à ce stade du procédé s'étendent au-delà de la surface inférieure et de la surface supérieure de la structure revêtue 10, 12. A une septième étape (figure 3(f)), un traitement abrasif est appliqué aux surfaces exposées des parties métalliques 17 pour qu'elles affleurent respectivement les surfaces inférieure et supérieure de la structure revêtue 10, 12 (figure 3(g)) et qu'elles soient planes et lisses. Ce traitement est effectué au moyen d'un outil mécanique abrasif, par exemple un outil de rodage à disque rotatif abrasif 18, du côté de la surface supérieure ou inférieure de la pièce composite 10, 12, 17 puis ladite pièce est retournée et le traitement abrasif est effectué de l'autre côté. En variante, deux outils mécaniques abrasifs peuvent être utilisés simultanément des deux côtés de la pièce. La surface active abrasive du ou de chaque outil mécanique est par exemple un feutre chargé de grains abrasifs de plus grande dureté que le métal constituant les parties métalliques 17, tels que des grains de diamant, de carbure de silicium, d'alumine (corindon), de carbure de tungstène ou de nitrure de silicium. Le traitement abrasif peut être à sec. En variante, un fluide tel que de l'eau ou de l'huile peut être employé pour garantir la mobilité des grains abrasifs.

Selon l'invention, la matière choisie pour le revêtement 12 a une dureté égale ou supérieure à 80% de la dureté de la matière choisie pour les grains abrasifs, ces deux duretés étant mesurées (ou converties) en pascals. Par sa relative grande dureté, le revêtement 12 constitue ainsi une protection pour la structure en matériau de base 10 pendant le traitement abrasif et permet d'éviter le recours à des masques de protection rapportés. De préférence, la dureté du revêtement 12 est égale ou supérieure à celle de la matière abrasive afin d'optimiser la protection de la structure 10, laquelle est typiquement moins dure voire beaucoup moins dure que la matière abrasive. Des exemples de couples de matières possibles dans la présente invention sont le diamant pour le revêtement 12 et le diamant pour la matière abrasive, ou le diamant pour le revêtement 12 et le carbure de silicium pour la matière abrasive.

En pratique, donc, pendant le traitement abrasif, au moins les parties de la surface extérieure de la pièce composite 10,12,17 adjacentes aux parties métalliques 17, c'est-à-dire, dans l'exemple représenté, les surfaces supérieures des rebords 8 et les parties correspondantes 19 de la surface inférieure de la structure revêtue 10, 12 opposées à ces surfaces supérieures, ne sont recouvertes d'aucun moyen de protection. De préférence même, le traitement abrasif est effectué, de chacun des côtés de la pièce composite 10, 12, 17, jusqu'à ce que la surface active abrasive de l'outil, qui typiquement est plus grande que la pièce composite 10, 12, 17 et se déplace dans la direction de l'épaisseur de cette pièce composite en tournant sur elle-même, arrive au contact du revêtement 12. De cette manière, l'obtention d'une bonne qualité d'affleurement entre les surfaces abrasées des parties métalliques 17 et du revêtement 12 peut être garantie. Du fait de la grande dureté du revêtement 12, le traitement abrasif pourra être arrêté avant que le revêtement 12 ne soit complètement éliminé. Si le revêtement 12 est au moins aussi dur que la matière abrasive, il ne sera même pas affecté par ce traitement abrasif et servira de butée à la surface active abrasive pour définir une position d'arrêt où un affleurement est obtenu entre les surfaces abrasées des parties métalliques 17 et la surface extérieure du revêtement 12. Le balancier composite final obtenu par ce procédé présente ainsi un aspect esthétique de qualité. De plus, les opérations d'équilibrage (suppression du balourd) par enlèvement de petites parties des parties métalliques 17, 3 seront facilitées par le fait que la quantité de métal dans les cavités 7 est bien définie.

Suivant la forme de la pièce composite 10, 12, 17 et la géométrie et la taille de la surface active abrasive de l'outil, le traitement abrasif peut être mis en oeuvre sur toute la surface de la pièce composite 10, 12, 17 ou sélectivement sur certaines zones contenant les surfaces exposées des parties métalliques 17. Ainsi, dans l'exemple du balancier 1 tel que représenté, en ce qui concerne la surface supérieure de celui-ci, seul l'étage supérieur, c'est-à-dire la surface exposée supérieure des parties métalliques 17 et la surface supérieure des rebords 8, est soumis au traitement abrasif, la surface supérieure de la planche (de plus faible épaisseur) pouvant servir à recevoir des moyens de maintien de la pièce.

Pour mettre en oeuvre le traitement abrasif, plusieurs types d'outils abrasifs peuvent être utilisés, cumulativement ou non, pour roder et/ou rectifier et/ou polir les parties métalliques 17. Par ailleurs, un traitement abrasif électro-chimique pourrait être mis en oeuvre en complément du traitement abrasif mécanique.

Afin d'éviter que, pendant l'électro-formage, du métal se forme sur la structure revêtue 10, 12 ailleurs que dans les cavités 7, on utilisera comme matériau du revêtement 12 un matériau non conducteur. Par exemple, si du diamant est utilisé comme matériau du revêtement 12, on évitera de le doper au bore. En variante, avant l'électro-formage, on peut revêtir le revêtement 12 d'une couche sacrificielle non conductrice, par exemple une couche de silice ou de laque, couche qui, dans les zones où le traitement abrasif est appliqué, sera éliminée par le traitement abrasif et, dans les autres zones, pourra être enlevée par un traitement chimique.

Entre la première et la deuxième étape du procédé, il est possible de prévoir une étape intermédiaire consistant à former un revêtement intermédiaire sur la structure en matériau de base 10. Par exemple, dans le cas d'un matériau de base constitué de silicium, le revêtement intermédiaire peut être de l'oxyde de silicium formé par oxydation thermique sur le silicium pour augmenter sa résistance mécanique. Le revêtement 12 est ensuite déposé sur le revêtement intermédiaire.

Bien que, dans l'exemple décrit, le revêtement 12 protège de l'abrasion la structure en matériau de base 10, elle pourrait servir à protéger un revêtement intermédiaire formé entre la structure 10 et le revêtement 12 et ayant une dureté inférieure à celle de la structure 10.

Au lieu d'être formé sur toute la surface de la structure en matériau de base 10, comme décrit ci-dessus, le revêtement 12 pourrait, par un masquage, n'être formé que sur certaines zones entourant les ouvertures des cavités 11.

Les cavités 7 dans lesquelles sont formées les parties métalliques 17 pourraient n'être définies qu'en partie par la structure revêtue 10, 12, l'autre partie étant définie au cours du procédé par de la résine photosensible, comme illustré à la figure 10 de la demande de brevet WO 2008/135617. Par ailleurs, les cavités 7 pourraient n'être remplies que partiellement par les parties métalliques 17.

Il va de soi que le procédé selon l'invention peut être utilisé pour fabriquer des balanciers ayant une autre forme que celle du balancier 1 et même pour fabriquer d'autres composants horlogers que des balanciers. Par exemple, le procédé selon l'invention peut être appliqué à la fabrication de masses oscillantes du type de celles décrites dans la demande de brevet WO 2008/135817, c'est-à-dire comportant des parties métalliques à la périphérie d'une structure de plus faible masse volumique. Le procédé selon l'invention peut aussi être utilisé pour fabriquer des composants horlogers tels qu'une roue, un pignon, une ancre, un balancier, un ressort spiral, un ressort sautoir, une came, un plateau ou toute autre pièce devant être montée sur un axe rotatif ou fixe. Dans ce cas, une partie métallique annulaire est électro-formée dans une cavité du composant et c'est cette partie métallique qui est destinée à recevoir l'axe pour protéger la structure de base du composant lors du chassage. Ici, la mise à niveau des surfaces exposées de la partie métallique et du revêtement permise par la présente invention non seulement améliore l'esthétique du composant, mais aussi facilite le positionnement du composant sur une portée de l'axe, par exemple.

En pratique, on pourra bien entendu fabriquer simultanément plusieurs composants, du même type ou de types différents, à partir d'une même plaque en matériau de base. Chaque composant restera attaché au reste de la plaque par des ponts de matière laissés pendant la gravure de préférence jusqu'à la fin de la septième étape du procédé. Dans ce cas, c'est toute la plaque qui sera revêtue du revêtement 12 puis soumise au traitement abrasif. Les composants seront ensuite libérés de la plaque par rupture des ponts de matière. En variante, la libération des composants peut intervenir avant, par exemple entre l'électro-formage et le traitement abrasif.

## Revendications

1. Procédé de fabrication d'une pièce composite, notamment pour un mouvement horloger, comprenant les étapes suivantes :
- réaliser une structure (10) par gravure d'un premier matériau,
- former au moins un revêtement (12) sur la structure (10), la structure revêtue (10, 12) obtenue comprenant une surface extérieure,
- remplir d'un deuxième matériau (17), différent du premier matériau, et par électro-formage, au moins une cavité (7) définie par la structure revêtue (10, 12), le revêtement ou l'un au moins des revêtements (12) étant en un matériau non conducteur ou
étant revêtu d'une couche sacrificielle non conductrice afin d'éviter que pendant l'électro-formage le deuxième matériau (17) se forme aussi sur la structure revêtue (10, 12) ailleurs que dans ladite au moins une cavité (7), et
- abraser au moins une partie exposée du deuxième matériau (17)
au moyen d'une matière abrasive,
**caractérisé en ce que** le revêtement ou ledit un au moins des revêtements (12) présente une dureté, exprimée en pascals, égale à au moins 80% de la dureté de la matière abrasive.

2. Procédé selon la revendication 1, **caractérisé en ce que** le revêtement ou ledit un au moins des revêtements (12) est au moins aussi dur que la matière abrasive.

3. Procédé selon la revendication 1 ou 2, **caractérisé en ce qu'**au moins une partie de ladite surface extérieure adjacente à ladite partie exposée du deuxième matériau (17) est laissée exposée pendant l'opération d'abrasion.

4. Procédé selon la revendication 3, **caractérisé en ce qu'**au moins ladite partie de la surface extérieure adjacente à ladite partie exposée du deuxième matériau (17) est soumise à l'opération d'abrasion.

5. Procédé selon l'une quelconque des revendications 1 à 4, **caractérisé en ce que** l'opération d'abrasion est effectuée au moyen d'un outil mécanique (18) comprenant ladite matière abrasive, et **en ce que** l'outil mécanique (18) entre en contact avec le revêtement ou ledit un au moins des revêtements (12) pendant l'opération d'abrasion pour faciliter l'obtention d'un affleurement entre le deuxième matériau (17) et le revêtement ou ledit un au moins des revêtements (12).

6. Procédé selon l'une quelconque des revendications 1 à 5, **caractérisé en ce que** le revêtement ou ledit un au moins des revêtements (12) est formé sur sensiblement toutes les surfaces de la structure (10).

7. Procédé selon l'une quelconque des revendications 1 à 6, **caractérisé en ce que** l'opération d'abrasion est un rodage et/ou une rectification et/ou un polissage.

8. Procédé selon l'une quelconque des revendications 1 à 7, **caractérisé en ce que** le revêtement ou ledit un au moins des revêtements (12) est formé par dépôt chimique en phase vapeur, dépôt physique en phase vapeur, pulvérisation, évaporation, trempage ou traitement thermique.

9. Procédé selon l'une quelconque des revendications 1 à 8, **caractérisé en ce que** le premier matériau est du silicium, du quartz, du verre, du carbure de silicium, de l'alumine, de l'oxyde de zirconium ou une autre céramique.

10. Procédé selon l'une quelconque des revendications 1 à 9, **caractérisé en ce que** le revêtement ou ledit un au moins des revêtements (12) est en l'une des matières suivantes : diamant, carbure de silicium, alumine, carbure de tungstène, nitrure de silicium.

11. Procédé selon l'une quelconque des revendications 1 à 10, **caractérisé en ce que** la matière abrasive est du diamant, du carbure de silicium, de l'alumine, du carbure de tungstène ou du nitrure de silicium.

12. Procédé selon l'une quelconque des revendications 1 à 11, **caractérisé en ce que** le premier matériau est du silicium et le revêtement ou ledit un au moins des revêtements (12) est en diamant ou carbure de silicium.

13. Procédé selon l'une quelconque des revendications 1 à 12, **caractérisé en ce que** le deuxième matériau (17) est un métal.

14. Procédé selon l'une quelconque des revendications 1 à 13, **caractérisé en ce que** le revêtement ou ledit un au moins des revêtements (12) est plus dur que le premier matériau.

15. Procédé selon l'une quelconque des revendications 1 à 14, **caractérisé en ce qu'**un revêtement intermédiaire est formé entre la structure (10) et ledit un au moins des revêtements (12) et **en ce que** ledit un au moins des revêtements (12) est plus dur que ce revêtement intermédiaire.

16. Procédé selon l'une quelconque des revendications 1 à 15, **caractérisé en ce que** la pièce composite est un composant horloger choisi parmi les composants suivants : balancier, masse oscillante, roue, pignon, came, ancre, plateau, ressort spiral, ressort sautoir.

## Patentansprüche

1. Verfahren zur Herstellung eines Verbundwerkstoffteils, insbesondere für Uhrwerke, das die folgenden Schritte umfasst:
- Ausführen einer Struktur (10) durch Gravur eines ersten Materials,
- Bilden von mindestens einem Überzug (12) auf der Struktur (10), wobei die erhaltene überzogene Struktur (10, 12) eine Außenfläche umfasst,
- Füllen mindestens eines Hohlraums (7), der durch die überzogene Struktur (10, 12) abgegrenzt ist, mit einem zweiten Material (17), das sich von dem ersten Material unterscheidet, und durch Elektroformung, wobei der Überzug oder der mindestens eine der Überzüge (12) aus einem nicht leitfähigen Material hergestellt oder mit einer nicht leitfähigen Opferschicht überzogen ist, um zu verhindern, dass das zweite Material (17) sich während des Elektroformens auch auf der überzogenen Struktur (10, 12) außerhalb des mindestens einen Hohlraums (7) bildet, und
- Abschleifen von mindestens einem freiliegenden Teil des zweiten Materials (17) mittels eines Schleifmittels,
**dadurch gekennzeichnet, dass** der Überzug oder der mindestens eine der Überzüge (12) eine in Pascal ausgedrückte Härte aufweist, die gleich mindestens 80 % der Härte des Schleifmittels beträgt.

2. Verfahren nach Anspruch 1, **dadurch gekennzeichnet, dass** der Überzug oder der mindestens eine der Überzüge (12) mindestens genauso hart ist wie das Schleifmittel.

3. Verfahren nach Anspruch 1 oder 2, **dadurch gekennzeichnet, dass** zumindest ein Teil der Außenfläche, die dem freiliegenden Teil des zweiten Materials (17) benachbart ist, während des Arbeitsgangs des Abschleifens freiliegend gelassen wird.

4. Verfahren nach Anspruch 3, **dadurch gekennzeichnet, dass** zumindest der Teil der Außenfläche, die dem freiliegenden Teil des zweiten Materials (17) benachbart ist, dem Arbeitsgang des Abschleifens unterzogen wird.

5. Verfahren nach einem der Ansprüche 1 bis 4, **dadurch gekennzeichnet, dass** der Arbeitsgang des Abschleifens mittels eines mechanischen Werkzeugs (18) durchgeführt wird, das das Schleifmittel umfasst, und dadurch, dass das mechanische Werkzeug (18) während des Arbeitsgangs des Abschleifens mit dem Überzug oder dem mindestens einen der Überzüge (12) in Berührung gelangt, um den Erhalt einer Bündigkeit zwischen dem zweiten Material (17) und dem Überzug oder dem mindestens einen der Überzüge (12) zu erleichtern.

6. Verfahren nach einem der Ansprüche 1 bis 5, **dadurch gekennzeichnet, dass** der Überzug oder der mindestens eine der Überzüge (12) auf im Wesentlichen allen Flächen der Struktur (10) gebildet wird.

7. Verfahren nach einem der Ansprüche 1 bis 6, **dadurch gekennzeichnet, dass** der Arbeitsvorgang des Abschleifens ein Läppen und/oder ein Schleifen und/oder ein Polieren ist.

8. Verfahren nach einem der Ansprüche 1 bis 7, **dadurch gekennzeichnet, dass** der Überzug oder der mindestens eine der Überzüge (12) durch chemische Beschichtung aus der Dampfphase, physikalische Beschichtung aus der Dampfphase, Zerstäubung, Verdampfung, Beschichtung durch Eintauchen oder Wärmebehandlung gebildet wird.

9. Verfahren nach einem der Ansprüche 1 bis 8, **dadurch gekennzeichnet, dass** das erste Material Silizium, Quarz, Glas, Siliziumkarbid, Tonerde, Zirkonoxid oder eine andere Keramik ist.

10. Verfahren nach einem der Ansprüche 1 bis 9, **dadurch gekennzeichnet, dass** der Überzug oder der mindestens eine der Überzüge (12) aus einem der folgenden Materialien besteht: Diamant, Siliziumkarbid, Tonerde, Wolframkarbid, Siliziumnitrid.

11. Verfahren nach einem der Ansprüche 1 bis 10, **dadurch gekennzeichnet, dass** das Schleifmittel aus Diamant, Siliziumkarbid, Tonerde, Wolframkarbid oder Siliziumnitrid besteht.

12. Verfahren nach einem der Ansprüche 1 bis 11, **dadurch gekennzeichnet, dass** das erste Material Silizium ist und der Überzug oder der mindestens eine der Überzüge (12) aus Diamant oder Siliziumkarbid besteht.

13. Verfahren nach einem der Ansprüche 1 bis 12, **dadurch gekennzeichnet, dass** das zweite Material (17) ein Metall ist.

14. Verfahren nach einem der Ansprüche 1 bis 13, **dadurch gekennzeichnet, dass** der Überzug oder der mindestens eine der Überzüge (12) härter ist als das erste Material.

15. Verfahren nach einem der Ansprüche 1 bis 14, **dadurch gekennzeichnet, dass** ein Zwischenüberzug zwischen der Struktur (10) und dem mindestens einen der Überzüge (12) gebildet wird und dass der mindestens eine der Überzüge (12) härter ist als dieser Zwischenüberzug.

16. Verfahren nach einem der Ansprüche 1 bis 15, **dadurch gekennzeichnet, dass** das Verbundwerkstoffteil ein Uhrenbauteil ist, das unter den folgenden Bauteilen ausgewählt wird: Unruh, Schwungmasse, Rad, Trieb, Kurvenscheibe, Anker, Schale, Spiralfeder, Hebelfeder.

## Claims

1. A method for manufacturing a composite part, notably for a timepiece movement, comprising the following steps :
- making a structure (10) by etching a first material,
- forming at least one coating (12) on the structure (10), the coated structure (10, 12) obtained comprising an outer surface,
- filling at least one cavity (7) defined by the coated structure (10, 12) with a second material, different from the first material, and by electroforming, the coating or at least one of the coatings (12) being of a nonconductive material or being coated with a sacrificial nonconductive layer so as to prevent the second material (17) from being formed also on the coated structure (10, 12) elsewhere than in said at least one cavity (7) during the electroforming, and
- abrading at least one exposed portion of the second material (17) by
means of an abrasive material,
**characterised in that** the coating or said at least one of the coatings (12) has a hardness, expressed in Pascal, equal to at least 80% of the hardness of the abrasive material.

2. The method according to claim 1, **characterised in that** the coating or said at least one of the coatings (12) is at least as hard as the abrasive material.

3. The method according to claim 1 or 2, **characterised in that** at least a portion of said outer surface adjacent to said exposed portion of the second material (17) is left exposed during the abrasion operation.

4. The method according to claim 3, **characterised in that** at least said portion of the outer surface adjacent to said exposed portion of the second material (17) is subject to the abrasion operation.

5. The method according to any one of claims 1 to 4, **characterised in that** the abrasion operation is performed by means of a mechanical tool (18) comprising said abrasive material, and **in that** the mechanical tool (18) comes into contact with the coating or said at least one of the coatings (12) during the abrasion operation to facilitate obtaining a levelling between the second material (17) and the coating or said at least one of the coatings (12).

6. The method according to any one of claims 1 to 5, **characterised in that** the coating or said at least one of the coatings (12) is formed on substantially all surfaces of the structure (10).

7. The method according to any one of claims 1 to 6, **characterised in that** the abrasion operation is a lapping and/or a grinding and/or a polishing.

8. The method according to any one of claims 1 to 7, **characterised in that** the coating or said at least one of the coatings (12) is formed by vapour phase chemical deposition, vapour phase physical deposition, sputtering, evaporation, tempering or heat treatment.

9. The method according to any one of claims 1 to 8, **characterised in that** the first material is silicon, quartz, glass, silicon carbide, alumina, zirconium oxide or another ceramic.

10. The method according to any one of claims 1 to 9, **characterised in that** the coating or said at least one of the coatings (12) is of one of the following materials: diamond, silicon carbide, alumina, tungsten carbide, silicon nitride.

11. The method according to any one of claims 1 to 10, **characterised in that** the abrasive material is diamond, silicon carbide, alumina, tungsten carbide or silicon nitride.

12. The method according to any one of claims 1 to 11, **characterised in that** the first material is silicon and the coating or said at least one of the coatings (12) is of diamond or silicon carbide.

13. The method according to any one of claims 1 to 12, **characterised in that** the second material (17) is a metal.

14. The method according to any one of claims 1 to 13, **characterised in that** the coating or said at least one of the coatings (12) is harder than the first material.

15. The method according to any one of claims 1 to 14, **characterised in that** an intermediate coating is formed between the structure (10) and said at least one of the coatings (12) and **in that** said at least one of the coatings (12) is harder than this intermediate coating.

16. The method according to any one of claims 1 to 15, **characterised in that** the composite part is a timepiece component selected from the following components: balance, oscillating weight, wheel, pinion, cam, pallets, plate, hairspring, jumper spring.
